(19) Europäisches Patentamt
European Patent Office
Office européen des brevets

(11) **EP 3 809 203 A1**

(12) **EUROPEAN PATENT APPLICATION**

(43) Date of publication:
**21.04.2021 Bulletin 2021/16**

(51) Int Cl.:
**G03F 7/20** (2006.01)     **G06K 9/62** (2006.01)

(21) Application number: **19203752.1**

(22) Date of filing: **17.10.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **KEYVANI JANBAHAN, Aliasghar**
  **5500 AH Veldhoven (NL)**
• **SPIERING, Frans Reinier**
  **5500 AH Veldhoven (NL)**
• **WILDENBERG, Jochem Sebastiaan**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHODS OF FITTING MEASUREMENT DATA TO A MODEL AND MODELING A PERFORMANCE PARAMETER DISTRIBUTION AND ASSOCIATED APPARATUSES**

(57) Disclosed is a method of fitting measurement data to a model. The method comprises obtaining measurement data relating to a performance parameter for at least a portion of a substrate; and fitting the measurement data to the model by minimizing a complexity metric applied to fitting parameters of the model while not allowing the deviation between the measurement data and the fitted model to exceed a threshold value.

Fig. 4

EP 3 809 203 A1

## Description

BACKGROUND

Field of the Invention

The present invention relates to methods and apparatus for applying patterns to a substrate in a lithographic process.

Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In performing lithographic processes, such as application of a pattern on a substrate or measurement of such a pattern, process control methods are used to monitor and control the process. Such process control techniques are typically performed to obtain corrections for control of the lithographic process. It would be desirable to improve such process control methods.

SUMMARY OF THE INVENTION

In a first aspect of the invention, there is provided a method of fitting measurement data to a model, comprising: obtaining measurement data relating to a performance parameter for at least a portion of a substrate; and fitting the measurement data to the model by minimizing a complexity metric applied to fitting parameters of the model while not allowing the deviation between the measurement data and the fitted model to exceed a threshold value .

In a second aspect of the invention, there is provided a method for modeling a performance parameter distribution comprising: obtaining measurement data relating to a performance parameter for at least a portion of a substrate; and modeling the performance parameter distribution based on the measurement data by optimization of a model, wherein the optimization minimizes a cost function representing a complexity of the modeled performance parameter distribution subject to a constraint that substantially all points comprised within the measurement data are within a threshold value from the modeled performance parameter distribution.

In other aspects of the invention, there is provided a computer program comprising program instructions operable to perform the method of the first aspect when run on a suitable apparatus, a processing device comprising a processor and storage with such a computer program and a lithographic apparatus with such a processing device.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

> Figure 1 depicts a lithographic apparatus together with other apparatuses forming a production facility for semiconductor devices;
> Figure 2 shows exemplary sources of processing parameters;
> Figure 3 illustrates schematically a current method of determining corrections for control of a lithographic apparatus;
> Figure 4 is an overlay plot conceptually illustrating support vector machine regression optimization; and
> Figure 5(a) and (b) are cumulative yield plots of percentage yield against overlay error in the x and y directions respectively.

DETAILED DESCRIPTION

Before describing embodiments of the invention in detail, it is instructive to present an example environment in which embodiments of the present invention may be implemented.

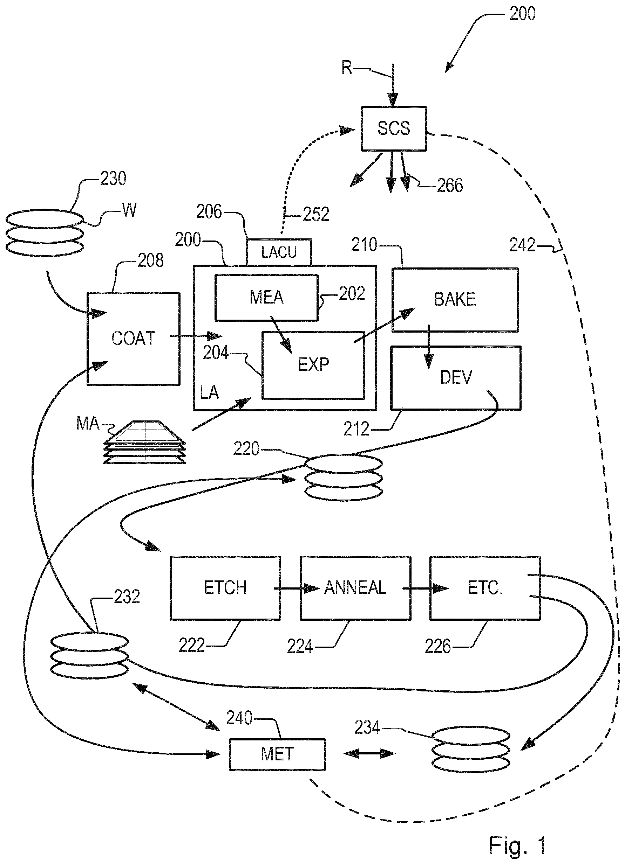

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a pattern transfer unit or projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Various techniques may be used to improve the accuracy of reproduction of patterns onto a substrate. Accurate reproduction of patterns onto a substrate is not the only concern in the production of ICs. Another concern is the yield, which generally measures how many functional devices a device manufacturer or a device manufacturing process can produce per substrate. Various approaches can be employed to enhance the yield. One such approach attempts to make the production of devices (e.g., imaging a portion of a design layout onto a substrate using a lithographic apparatus such as a scanner) more tolerant to perturbations of at least one of the processing parameters during processing a substrate, e.g., during imaging of a portion of a design layout onto a substrate using a lithographic apparatus. The concept of overlapping process window (OPW) is a useful tool for this approach. The production of devices (e.g., ICs) may include other steps such as substrate measurements before, after or during imaging, loading or unloading of the substrate, loading or unloading of a patterning device, positioning of a die underneath the projection optics before exposure, stepping from one die to another, etc. Further, various patterns on a patterning device may have different process windows (i.e., a space of processing parameters under which a pattern will be produced within specification). Examples of pattern specifications that relate to a potential systematic defect include checks for necking, line pull back, line thinning, CD, edge placement, overlapping, resist top loss, resist undercut and/or bridging. The process window of all or some (usually patterns within a particular area) of the patterns on a patterning device may be obtained by merging (e.g., overlapping) process windows of each individual pattern. The process window of these patterns is thus called an overlapping process window. The boundary of the OPW may contain boundaries of process windows of some of the individual patterns. In another words, these individual patterns limit the OPW. These individual patterns can be referred to as "hot spots" or "process window limiting patterns (PWLPs)," which are used interchangeably herein. When controlling a lithography process, it is possible, and typically economical, to focus on the hot spots. When the hot spots are not defective, it is likely that all the patterns are not defective. The imaging becomes more tolerant to perturbations when values of the processing parameters are closer to the OPW if the values of the processing parameters are outside the OPW, or when the values of the processing parameters are farther away from the boundary of the OPW if the values of the processing parameters are inside the OPW.

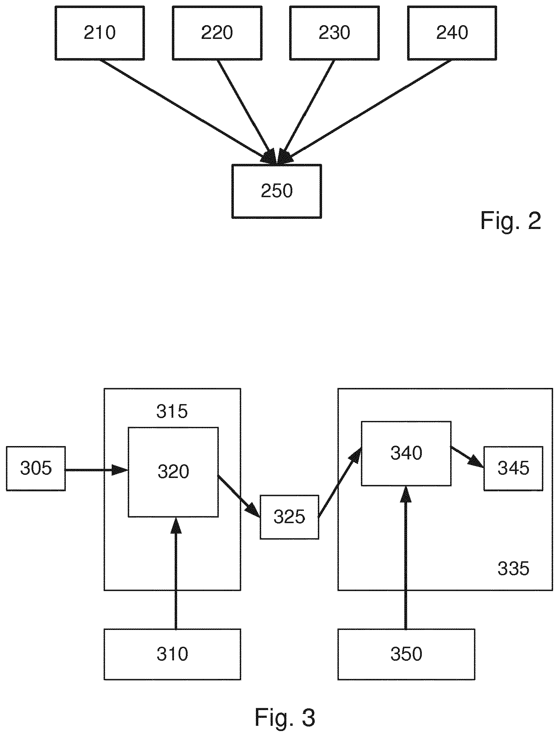

Figure 2 shows exemplary sources of processing parameters 250. One source may be data 210 of the processing apparatus, such as parameters of the source, projection optics, substrate stage, etc. of a lithography apparatus, of a track, etc. Another source may be data 220 from various substrate metrology tools, such as a substrate height map, a focus map, a critical dimension uniformity (CDU) map, etc. Data 220 may be obtained before the applicable substrate was subject to a step (e.g., development) that prevents reworking of the substrate. Another source may be data 230 from one or more patterning device metrology tools, patterning device CDU map, patterning device (e.g., mask) film stack parameter variation, etc. Yet another source may be data 240 from an operator of the processing apparatus.

Control of the lithographic process are typically based on measurements fed back or fed forward and then modelled using, for example interfield (across-substrate fingerprint) or intrafield (across-field fingerprint) models. Within a die, there may be separate functional areas such as memory areas, logic areas, contact areas etc. Each different functional area, or different functional area type may have a different process window, each with a different processes window center. For example, different functional area types may have different heights, and therefore different best focus settings. Also, different functional area types may have different structure complexities and therefore different focus tolerances (focus process windows) around each best focus. However, each of these different functional areas will typically be formed using the same focus (or dose or position etc.) setting due to control grid resolution limitations.

The lithographic control is typically performed using offline calculation of one or more set-point corrections for one or more particular control degrees of freedom, based on (for example) measurements of previously formed structures. The set-point corrections may comprise a correction for a particular process parameter, and may comprise the correction of a setting of a particular degree of freedom to compensate for any drift or error such that the measured process parameter remains within specification (e.g., within an allowed variation from a best set-point or best value; for example, an OPW or process window). For example, an important process parameter is focus, and a focus error may manifest itself in a defective structure being formed on a substrate. In a typical focus control loop, a focus feedback methodology may be used. Such a methodology may comprise a metrology step which may measure the focus setting used on a formed structure; e.g., by using diffraction based focus (DBF) techniques in which a target with focus dependent asymmetry is formed such that the focus setting can be subsequently determined by measurement of the asymmetry on the target. The measured focus setting may then be used to determine, offline, a correction for the lithographic process; for example a positional correction for one or both of the reticle stage or substrate stage which corrects the focus offset (defocus). Such an offline positional correction may then be conveyed to the scanner as a set-point best focus correction, for direct actuation by the scanner. The measurements may be obtained over a number of lots, with an average (over the lots) best focus correction applied to each substrate of one or more subsequent lots. Similar control loops are used in the other two dimensions (substrate plane) to control and minimize overlay error.

Figure 3 illustrates such a methodology. It shows product information 305, such as product layout, illumination mode, product micro-topography etc., and metrology data 310 (e.g., defocus data or overlay data measured from previously produced substrates) being fed to an offline processing device 315 which performs an optimization algorithm 320. The output of the optimization algorithm 320 is one or more set-point corrections/offsets 325, e.g., for actuators which control reticle stage and/or substrate stage positioning (in any direction, i.e., in the x, y and/or z directions, where x and y are the substrate plane direction and z is perpendicular to x and y) within scanner 335; the set-point corrections 325 being calculated to compensate for any offsets/errors (e.g., defocus, dose or overlay offsets/errors) comprised within the metrology data 310. A control algorithm 340 (e.g., leveling algorithm) calculates control set-points 345 using substrate specific metrology data 350. For example, a leveling exposure trajectory (e.g., determining a relative movement or acceleration profile for positioning of the substrate stage relative to the reticle stage during the lithographic process) may be calculated using leveling data (e.g., a wafer height map) and outputs positional set-points 345 for the scanner actuators. The scanner 335 directly applies, equally for each substrate, the set-point corrections 325 to the calculated set-points 345. In other control arrangements, the optimization may be performed within the scanner to provide optimized corrections on a per-wafer basis (wafer-to-wafer control).

The optimization algorithm (e.g., as performed within an offline processing device and/or scanner) may be based on a number of different merit functions, one for each control regime. As such, in the example described above, a levelling (or focus) merit function is used for the focus control (scanner z direction control), which is different to an overlay (scanner x/y direction control) merit function, a lens aberration correction merit function etc.. In other embodiments, control may be co-optimized for one or more of these control regimes.

Regardless of the control regime and control aspect being optimized, existing optimization methods often rely on performing a least squares (e.g., root-mean-square (RMS)) regression based optimization or similar such regression. Such methods result in all the measurements being given equal importance, although some measurements suffer more from noise and uncorrectable errors than other ones. More importantly, existing methods may attempt to correct dies having a small overlay error and as such will yield anyway, potentially at the expense of pushing otherwise marginally yielding dies out of specification. When all the measurements have the same weight, the estimator tries to find a compromise between all the measurements to reduce the error everywhere. This means that even the easily yielding points are pushed down, which can push other dies out of specification. Such methods are sensitive to noisy data and lack of measurement points. Also, such methods can estimate overly high values for the fingerprints, which later in the optimization may waste the actuator potential (actuation range) for no additional benefit. Note that the larger the estimated fingerprint parameters, the higher the risk of reaching the limit of the actuator capability in the optimization.

Such RMS type regression methods have a tendency to overfit or underfit, and there is no direct control on the level of fitting. In case of overfitting, the calculated fingerprints exceed the actual value which can be very problematic. Normalized model uncertainty (nMU) may be used, together with projection ratios, to predict and prevent overfitting by reducing the complexity of the model; however these methods limit the choice of model. For example, it is common knowledge that a 3rd order model cannot be fitted to only two data points, etc.. However, this can be made possible by adding other constraints or cost functions to the fitting problem. This practice, which is called regularization in machine learning, can help to fit a model that, in a probabilistic sense, has lower out-of-sample error.

To address these issues, it is proposed to use a modified version of a support vector machines (SVM) regression technique instead of a least-squares fitting in the estimation part of an optimization. Such an optimization technique will use a different cost function and different set of constraints compared to the existing least squares method.

As such, disclosed herein is a method for controlling a lithographic apparatus configured to provide product structures to a substrate in a lithographic process, the method comprising: obtaining metrology data related to the substrate; and optimizing a control merit function for the lithographic apparatus based on said metrology data, said optimizing comprising performing a support vector machines regression on said control merit function.

Aims of such a method comprise determining fingerprints such that:

- The fingerprints are robust to noisy data.
- The fingerprints can deal comfortably with less or sparse metrology data. This can reduce the metrology load and increase throughput.
- The fingerprints are as small as possible (but not smaller) so that actuator range is not wasted. This can free up the budget for other corrections.
- No overfitting is possible: To keep the out-of-sample error as close as possible to the in-sample error, machine learning techniques (including the SVM) try to achieve a model that has least possible variance to the sampling. This is done via margin maximization and regularization. Such a technique would statistically have a small error at the non-measured locations. By contrast a least squared method only minimizes the error for in-sample errors (measured points).
- The estimated fingerprint model describes the measured data sufficiently well.

The SVM regression method works by essentially sacrificing/compromising where the overlay value is small (e.g., within a threshold $\varepsilon$), and using that freedom to correct dies with larger errors (e.g., which would otherwise be almost yielding dies). More specifically, the SVM regression method attempts to find a function f(x) that has at most $\varepsilon$ deviation from known values (e.g., training data) for all of the training data, and at the same time is as flat (non-complex) as possible. In other words, errors are accepted and ignored provided they are less than $\varepsilon$. Deviations larger than this are not tolerated in the basic SVM regression; however, in practical circumstances the resultant optimization problem will typically not be feasible. To address this, slack variables $\xi_i$, $\xi_i^*$ may be used to accommodate outliers.

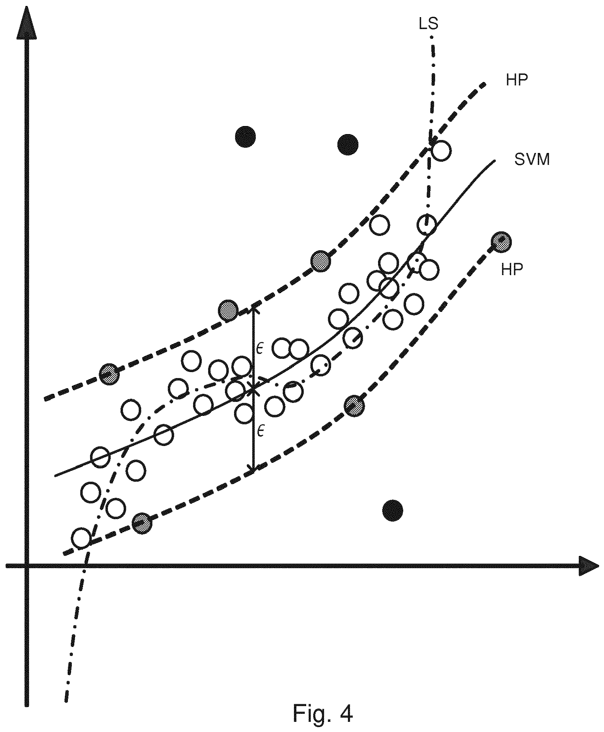

Figure 4 conceptually illustrates the SVM regression. Figure 4 is an overlay plot (e.g., a plot of an overlay component (e.g., dx or dy) against a wafer location coordinate) with each point on the Figure representing an overlay error value. Note that this is only a 2D plot for ease of representation, in actual overlay modeling, both dx and dy overlay components will be modelled as a function of x and y. The parameter $\varepsilon$ defines an acceptable margin or overlay error, and can be chosen by a user. The white points inside of the dashed lines HP (which denote the extent of the hyperplane defined by the margin $\varepsilon$), i.e., those points having a magnitude smaller than $\varepsilon$, do not contribute to the cost. In other words these values are essentially ignored when performing the SVM regression; they are considered to represent an overlay that is good enough and therefore not requiring any correction. The gray points are the points closest to the hyperplane; these are called the support vector points. The support vector points are the basis functions which determine the SVM regression (solid line) SVM. The black points are outliers or error support vectors. Slack variables are used to cope with these, such that their distance from dashed lines are minimized (e.g., first norm). In this way, the model SVM produced by SVM regression only depends on a subset of the training data, because the cost function for building the model ignores any training data that is close (within a threshold $\varepsilon$) to the model prediction. For contrast, a least-squares fit LS to the same data points is also shown (dot-dash line), which displays signs of overfitting (being overly complex).

A highly simplified mathematical description of the difference between the least square regression and SVM regression will now be described. Although the example uses overlay as a direct use case, the methodology is in no way specific for estimating overlay fingerprints. The SVM regression techniques disclosed herein are equally suitable for fingerprint estimation of any parameter such as focus, critical dimension (CD), alignment, edge placement error, etc. and/or any optimization comprised within lithographic process control.

For both least squares and SVM regression cases, the model can be stated as:

$$Ax = b$$

Where A is the so called "Design Matrix", generated by evaluating the overlay (or other parameter) model on the measurement grid; the term x is the so called "model parameter", and is a vector comprising the fingerprint parameters: e.g. "k-parameters" or parameters of a typical 6 parameter model (x/y translation parameters: Tx, Ty, symmetric/asymmetric magnification parameters: Ms, Ma, symmetric/asymmetric rotation parameters: Rs, Ra) or of any other suitable model for modeling a fingerprint; and the term *b* is a vector comprising all the measured overlay values in both x and y directions (i.e., metrology data). The aim of a least squares regression optimization is to find the model parameters *x* which minimizes *Ax - b;* i.e., the least square method minimizes the 2-norm of the error in the equation *Ax = b*:

$$\min_{x}\|Ax - b\|$$

where ∥.∥ is the 2-norm operator. Note that the italicized "*x*" will be used throughout to denote the model parameter term, in contrast to the non-italicized "x" which denotes a spatial coordinate.

By contrast, in an SVM regression technique, the optimization aims to minimize the "complexity" of the fingerprint parameters subject to the constraint that all the measurements are "sufficiently explained" by the model.

The complexity of fingerprint parameters can be defined as the 2-norm of the vector holding the parameter values except for any zeroth order parameters (e.g., such as the translation parameters Tx and Ty in an overlay model). To better understand the concept of complexity in this context, the following concepts from machine learning should be understood:

- **Generalization:** suppose a model is to be fitted onto a data set. A first proportion (e.g., the first half) of the data is used to train (fit) your model and a second proportion (e.g., the second half) of the data is used to validate the model once trained. The first proportion of the data is typically referred to as in-sample data and the second proportion of the data is typically referred out-of-sample data. A ratio between the in-sample error and out-of-sample error is a measure of generalizability of the model; i.e., a measure of how successful the model is at representing the out-of-sample data which was not used (not taken into account) in the fitting process.

- **VC-dimension:** Vapnik-Chervonenkis (VC) dimension is a measure of complexity of the model. In neural networks the VC dimension is normally measured using dichotomies. Generally: the lower the VC dimension, the more generalizable is the fit. For example: A second order model on one dimensional data comprising a total of three parameters can be better generalized than a third order model with a total of four parameters fitted on the same data (in such a case the number of the parameters is equal to the VC dimension). It should be appreciated that, while it is commonly stated that the number of the parameters should not exceed the number of measurements, this is not generally true. It is actually the number of VC dimensions (not parameters) which should be fewer than the number of the measurements. The number of parameters is not necessarily equal to the VC dimension. For example, it is possible to fit a 1000 parameter model with data comprising 10 measurements; however, the complexity of the fit, as defined with VC dimension should not be higher than 10.

Fitting a full infinite dimensional model onto a given data set remains possible; a common practice in fitting nonlinear models such as *f(A,x) = b* is by using kernel functions. By such techniques, it is possible to keep the VC dimension low while the model itself has infinite number of parameters, which means that the out-of-sample error can be kept low.

Keeping the out-of-sample error close to in-sample error can be achieved using regularization techniques. Regularization is a technique which discourages the learning (or fitting) of a complex or flexible model (i.e., it favors simpler models), so as to keep the VC dimension low and avoid the risk of overfitting.

The VC dimension of a model can be minimized based on an optimization on the 2-norm of the parameter values except zeroth order terms (i.e., the bias). For the example of overlay, this means minimizing all the parameter values except the linear translation parameters (Tx and Ty). Later, it will become apparent why the VC dimension reduces by this optimization, such that it is low enough to be generalizable even if the overlay model has a very high number of parameters.

In order to keep the equations simple, assume for this example that the overlay data model can be written as:

$$Ax + t = b$$

Where t represents zeroth order (translation terms). Then the optimization problem for low complexity becomes a minimization of the 1-norm or 2-norm of the model parameters; e.g.:

$$\min_{x}\|x\|$$

Subject to the criterion that all the measurements are sufficiently explained by the model. Note that ∥*x*∥ is only one example of a complexity metric for minimization in the methods described herein. In other embodiments, a weighted norm may be minimized, for example:

$$\min_{x}\|Q^{1/2}x\| = \min_{x}\sqrt{x^{T}Qx}$$

where *Q* is any Positive-Definite square matrix size *of x*. *Q* can contain information on the expense of using a certain model parameter. For example, if it is undesirable to use a first parameter p1, but instead compensate for this (as much as possible) using a second parameter p2, a high weight may be given to the $Q$ element relating to parameter p1 with respect to the $Q$ element relating to parameter p2, such that the estimator is less likely to use parameter p1 as parameter p2. $Q$ can also be used to assign use relative costs to pairs or sets of parameters using off-diagonal elements of the $Q$ matrix.

This criterion means that, for each and every measurement j:

$$\left| \sum_i A_{ji} x_i + t - b_j \right| < \epsilon$$

where |.| signifies the absolute value. This constraint states that all the measured overlay values are fully explained by the model with an accuracy better than $\varepsilon$.

However, outliers and residuals are almost inevitable. Therefore, such outliers should be accommodated, yet penalized at the same time. This can be done by the provision of slack variables, with which the optimization problem can be written as:

$$\min_{x,\xi} \left( \|x\| + C \sum_j \left( \xi_j + \xi_j^* \right) \right)$$

Subject to:

$$\sum_i A_{ji} x_i - b_j < \epsilon + \xi_j$$

$$\sum_i A_{ji} x_i - b_j > -\epsilon - \xi_j^*$$

$$\xi_j, \xi_j^* > 0$$

Where $\xi$ and $\xi^*$ are the upper and lower slack variables allowing for outliers and C is outlier penalization coefficient, also called as "complexity coefficient". The constant C (>0) determines the trade-off between the flatness (complexity) of the fit and the degree to which deviations larger than $\varepsilon$ are tolerated through penalizing the outliers. The higher the complexity coefficient, the greater the freedom for the model to choose a complex model, to better represent the in-sample data. At one extreme, irrespective of the overlay model used to generate the $A$ matrix, if $C=0$, the solution will simply be only zeroth order translation. At the other extreme, C equals infinity would mean that the maximum error is always maintained smaller than a certain value regardless of the complexity; e.g., similar to an $L_\infty$ norm (absolute maximum) optimization ($L_\infty < \varepsilon$).

The optimization should determine a complexity coefficient C, margin $\varepsilon$ and slack variable $\xi$, such that that all the measured data is either represented by the model within an accuracy smaller than the (e.g., user defined) margin $\varepsilon$, or else, where this is not possible, their error ($\xi$) should be kept at a minimum provided that the solution does not become too complex as a result.

In order to convert this optimization problem to a quadratic programming optimization the method of Lagrange multipliers can be employed. Such a method converts a constrained problem into a form such that the derivative test of an unconstrained problem can still be applied. At any stationary point of the function that also satisfies the equality constraints, the gradient of the function at that point can be expressed as a linear combination of the gradients of the constraints at that point, with the Lagrange multipliers acting as coefficients. The relationship between the gradient of the function and gradients of the constraints leads to a reformulation of the original problem, known as the Lagrangian function. As such, Lagrange multipliers $\alpha, \alpha^*, \eta, \eta^*$ can be defined, and the Lagrangian function $L$ written as:

$$L := \frac{1}{2}\|x\| + C \sum_j \left( \xi_j + \xi_j^* \right) - \sum_j \left( \eta_j \xi_j + \eta_j^* \xi_j^* \right)$$

$$+ \sum_j \alpha_j \left( A_{ji} x_i + t - b_j - \epsilon - \xi_j \right)$$

$$+ \sum_j \alpha_j^* \left( -A_{ji} x_i - t + b_j - \epsilon - \xi_j^* \right)$$

This Lagrangian function L can be simply converted to a simple quadratic programming in the adjoint formulation, where the inner product of the data forms a cost function and C forms an inequality constraint:

$$\min \begin{cases} -\frac{1}{2} \sum_{k,l}^{all} (\alpha_k - \alpha_k^*)(\alpha_l - \alpha_l^*) \langle A_k, A_l \rangle \\ -\epsilon \sum_j^{all} (\alpha_j - \alpha_j^*) + \sum_j^{all} b_j (\alpha_j - \alpha_j^*) \end{cases}$$

Subject to:

$$\alpha_j^* \in [0, C]$$

$$\sum_j (\alpha_j - \alpha_j^*) = 0$$

The original model parameters x are a linear combination of the design matrix and the achieved optimum Lagrange multipliers:

$$x_i = \sum_j \left( \alpha_j - \alpha_j^* \right) A_{ji}$$

After solving the optimization problem, it becomes apparent that most of the $\alpha^{(*)}$ (i.e., $\alpha_j$ and $\alpha_j^*$) values are zero. Only few of the $\alpha^{(*)}$ values comprise non-zero values. The number of the non-zero $\alpha^{(*)}$ values is the VC dimension of this problem. Because of this, the entire model parameters can be written as a linear combination of only a few measurement points:

$$x_i = \sum_j \left( \alpha_j - \alpha_j^* \right) A_{ji}.$$

Even if the overlay model was of a very high order (e.g., of the order of 100 parameters), if only few (e.g., 6) $\alpha^{(*)}$ values are non-zero, the complexity of the model (the VC dimension) is 6, and the model is as generalizable as a six parameter ('6par') model. However both the in-sample and out-of-sample errors are as low as a 100 parameter model.

Each of the data values (columns of the matrix A) which correspond to a non-zero $\alpha^{(*)}$ and also contribute to the fingerprint parameters x is called a support vector, because they are vectors which support the hyperplane in the high dimensional space (hence the name support vector machine). In the specific example of the previous paragraph, there are 6 support vectors, each one of which being 100 dimensional and which together support a 100 dimensional hyperplane. It should be appreciated that it is not the error which is optimized, nor the parameters, but $\alpha^{(*)}$. The bias (or translation parameter for overlay case) is determined after optimization (e.g., using the Karush-Kuhn-Tucker (*KKT*) condition), which is not necessarily equal to the average of the data.

To summarize, it is proposed to use SVM regression to fit parameter fingerprints (e.g., overlay) as part of a lithographic process optimization. SVM regression in its currently known form cannot be directly applied to fingerprint data, due to its 2D nature whereas SVM in its general form can only deal with one dimensional data. Therefore, described herein is a modified version of the SVM technique which can be applied to 2D fingerprint data.

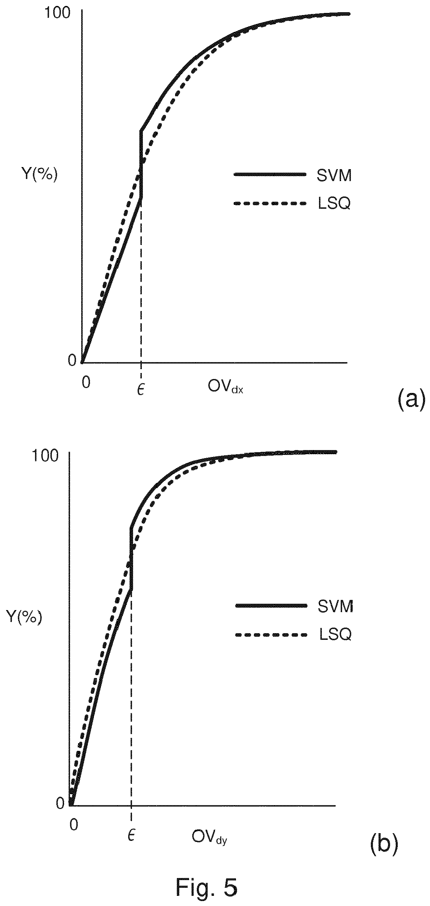

Figure 5 shows an example of the result of SVM modeling with a target margin $\varepsilon$ of 0.45nm, compared with modeling using least square fitting (LSQ) method. Figure 5(a) and 5(b) each show cumulative plots of in-sample errors (i.e., modeled errors at measurement points). The y-axis shows a cumulative number (as a percent) of measurement points below or equal to an in-sample error value of the overlay values $OV_{dx}$, $OV_{dy}$ (Figures 5(a) and 5(b) respectively). As SVM ignores measurement points within the target margin $\varepsilon$, SVM modeling typically results in fewer measurement points having an in-sample error below the target margin $\varepsilon$ compared to modeling using LSQ method. However, SVM modeling typically results in multiple measurement points having an in-sample error which is on the target margin (corresponding to the vertical section at $\varepsilon$ for each plot). Thus, SVM modeling is expected to result in better modeling (i.e., more measurement points having modeled errors less or equal to the target margin) than modeling using an LSQ method, as SVM sacrifices on low-error points in order to gain on high-error points. Therefore SVM can improve yield by concentrating all correction potential on larger errors without wasting correction potential on small errors.

The embodiments may further be described using the following clauses:

1. A method of fitting measurement data to a model, comprising:

   obtaining measurement data relating to a performance parameter for at least a portion of a substrate; and
   fitting the measurement data to the model by minimizing a complexity metric applied to fitting parameters of the model while not allowing a deviation between the measurement data and the fitted model to exceed a threshold value.

2. A method according to clause 1, wherein the complexity metric is 1-norm or 2-norm of the model parameters, or is 1-norm or 2-norm of weighted model parameters.

3. A method according to clause 1 or 2, wherein the complexity metric further comprises one or more slack variables to accommodate any outliers comprised within the measurement data, said deviation between the measurement data and the fitted model being allowed to exceed the threshold value for said outliers, and one or more coefficients for weighting the slack variables.

4. A method according to clause 3, wherein the one or more coefficients is a complexity coefficient which can be selected and/or optimized to determine the degree to which the outliers are penalized against the complexity of the fitting.

5. A method according to any preceding clause, wherein said measurement data comprises at least two-dimensional measurement data.

6. A method according to clause 5, wherein said fitting step comprises determining a two-dimensional fingerprint describing a spatial distribution of the performance parameter.

7. A method according to any preceding clause, further comprising defining Lagrange multipliers for said complexity metric, and converting the complexity metric into a Lagrangian function using the Lagrange multipliers.

8. A method according to clause 7, comprising converting the Lagrangian function into quadratic programming optimization.

9. A method according to clause 7 or 8, wherein said fitting step comprises determining model parameters as a linear combination of a design matrix and optimized values for said Lagrange multipliers.

10. A method according to any preceding clause, wherein said measurement data describes one or more of: a characteristic of the substrate; a characteristic of a patterning device which defines a pattern which is to be applied to the substrate; a position of one or both of a substrate stage for holding the substrate and a reticle stage for holding the patterning device; or a characteristic of a pattern transfer system which transfers the pattern on said patterning device to the substrate.

11. A method according to any preceding clause, wherein said measurement data comprises one or more of: overlay data, critical dimension data, alignment data, focus data, and levelling data.

12. A method according to any preceding clause, wherein the complexity metric relates to controlling a lithographic process, to optimize control of one or more of: exposure trajectory control in the directions parallel to a substrate plane; exposure trajectory control in the direction perpendicular to the substrate plane, lens aberration correction, dose control and laser bandwidth control for a source laser of the lithographic apparatus.

13. A method according to clause 12, comprising controlling the lithographic process according to said optimized control.

14. A method according to clause 12 or 13, wherein the lithographic process comprises exposure of a layer on a substrate, forming part of a manufacturing process for manufacturing an integrated circuit.

15. A method according to any preceding clause, the complexity metric is operable to minimize one or more of: overlay error, edge placement error, critical dimension error, focus error, alignment error and levelling error.

16. A method for modeling a performance parameter distribution comprising:

obtaining measurement data relating to a performance parameter for at least a portion of a substrate; and
modeling the performance parameter distribution based on the measurement data by optimization of a model, wherein the optimization minimizes a cost function representing a complexity of the modeled performance parameter distribution subject to a constraint that substantially all points comprised within the measurement data are within a threshold value from the modeled performance parameter distribution.

17. The method according to clause 16, wherein, where the measurement data comprises one or more outliers, said one or more outliers are allowed not to satisfy the constraint, and the cost function further comprises a penalization term to penalize said outliers which do not satisfy the constraint.

18. A method according to clause 17, wherein the penalization term comprises one or more slack variables to accommodate any outliers comprised within the measurement data, said constraint being relaxed for said outliers.

19. A method according to clause 18, wherein the penalization term further comprises a complexity coefficient which can be selected and/or optimized to determine the degree to which the outliers are penalized against the complexity of the fitting.

20. A method according to clause 16 to 19, further comprising defining Lagrange multipliers for said cost function, and converting the cost function into a Lagrangian function using the Lagrange multipliers.

21. A method according to clause 20, comprising converting the Lagrangian function into quadratic programming optimization .

22. A method according to clause 20 or 21, wherein said modeling step comprises determining model parameters as a linear combination of a design matrix and optimized values for said Lagrange multipliers.

23. A computer program comprising program instructions operable to perform the method of any of clauses 1 to 22, when run on a suitable apparatus.

24. A non-transient computer program carrier comprising the computer program of clause 23.

25. A processing device comprising storage means, said storage means comprising the computer program of clause 23; and
a processor operable to perform the method of any of clauses 1 to 22 responsive to said computer program.

26. A lithographic apparatus configured to provide product structures to a substrate in a lithographic process, comprising the processing device of clause 25.

27. A lithographic apparatus according to clause 26, further comprising:

a substrate stage for holding the substrate;
a patterning device stage for holding a patterning device; and
a pattern transfer unit for transferring a pattern on said patterning device onto said substrate.

28. A lithographic apparatus according to clause 27 comprising an actuator, said actuator for at least one of said substrate stage, patterning device stage and pattern transfer unit, and operable such that said actuator is controlled based on said fitted model.

29. A lithographic cell comprising
the lithographic apparatus of clause 26, 27 or 28; and
a metrology system operable to measure said measurement data.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of fitting measurement data to a model, comprising:

   obtaining measurement data relating to a performance parameter for at least a portion of a substrate; and
   fitting the measurement data to the model by minimizing a complexity metric applied to fitting parameters of the model while not allowing a deviation between the measurement data and the fitted model to exceed a threshold value.

2. A method as claimed in claim 1, wherein the complexity metric is 1-norm or 2-norm of the model parameters, or is 1-norm or 2-norm of weighted model parameters.

3. A method as claimed in claim 1, wherein the complexity metric further comprises one or more slack variables to accommodate any outliers comprised within the measurement data, said deviation between the measurement data and the fitted model being allowed to exceed the threshold value for said outliers, and one or more coefficients for weighting the slack variables.

4. A method as claimed in claim 3, wherein the one or more coefficients is a complexity coefficient which can be selected and/or optimized to determine the degree to which the outliers are penalized against the complexity of the fitting.

5. A method as claimed in claim 1, wherein said measurement data comprises at least two-dimensional measurement data.

6. A method as claimed in claim 5, wherein said fitting step comprises determining a two-dimensional fingerprint describing a spatial distribution of the performance parameter.

7. A method as claimed in claim 1, further comprising defining Lagrange multipliers for said complexity metric, converting the complexity metric into a Lagrangian function using the Lagrange multipliers and converting the Lagrangian function into quadratic programming optimization.

8. A method as claimed in claim 7, wherein said fitting step comprises determining model parameters as a linear combination of a design matrix and optimized values for said Lagrange multipliers.

9. A method as claimed in claim 1, wherein said measurement data describes one or more of: a characteristic of the substrate; a characteristic of a patterning device which defines a pattern which is to be applied to the substrate; a position of one or both of a substrate stage for holding the substrate and a reticle stage for holding the patterning device; or a characteristic of a pattern transfer system which transfers the pattern on said patterning device to the substrate.

10. A method as claimed in claim 1, wherein said measurement data comprises one or more of: overlay data, critical dimension data, alignment data, focus data, and levelling data.

11. A method as claimed in claim 1, wherein the complexity metric relates to controlling a lithographic process, to optimize control of one or more of: exposure trajectory control in the directions parallel to a substrate plane; exposure trajectory control in the direction perpendicular to the substrate plane, lens aberration correction, dose control and laser bandwidth control for a source laser of the lithographic apparatus.

12. A method as claimed in claim 11, comprising controlling the lithographic process according to said optimized control.

13. A method as claimed in claim 11, wherein the lithographic process comprises exposure of a layer on a substrate, forming part of a manufacturing process for manufacturing an integrated circuit.

14. A method as claimed in claim 1, the complexity metric is operable to minimize one or more of: overlay error, edge placement error, critical dimension error, focus error, alignment error and levelling error.

15. A non-transient computer program carrier comprising a computer program comprising program instructions operable to perform the method of claim 1, when run on a suitable apparatus.

Fig. 1

| 210 | 220 | 230 | 240 |

250

Fig. 2

315

305 → 320

310 →

325

340 → 345

335

350 →

Fig. 3

Fig. 4

(a)

(b)

Fig. 5

Europäisches
Patentamt

European
Patent Office

Office européen
des brevets

# EUROPEAN SEARCH REPORT

Application Number

EP 19 20 3752

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/238761 A1 (LIN SHUN-LI [TW] ET AL) 26 October 2006 (2006-10-26) * paragraphs [0009] - [0011]; claim 1 * ----- | 1-15 | INV. G03F7/20 G06K9/62 |
| Y | CHEN-CHIA CHUANG ET AL: "Robust least squares-support vector machines for regression with outliers", FUZZY SYSTEMS, 2008. FUZZ-IEEE 2008. (IEEE WORLD CONGRESS ON COMPUTATIONAL INTELLIGENCE). IEEE INTERNATIONAL CONFERENCE ON, IEEE, PISCATAWAY, NJ, USA, 1 June 2008 (2008-06-01), pages 312-317, XP031324782, ISBN: 978-1-4244-1818-3 * the whole document * ----- | 1-15 | |
| Y | SEONGBO SHIM ET AL: "Machine learning (ML)-based lithography optimizations", 2016 IEEE ASIA PACIFIC CONFERENCE ON CIRCUITS AND SYSTEMS (APCCAS), 1 October 2016 (2016-10-01), pages 530-533, XP055686784, DOI: 10.1109/APCCAS.2016.7804021 ISBN: 978-1-5090-1570-2 * the whole document * ----- | 2-8 | TECHNICAL FIELDS SEARCHED (IPC) G03F G06K |

The present search report has been drawn up for all claims

| Place of search | Date of completion of the search | Examiner |
|---|---|---|
| Munich | 17 April 2020 | Eisner, Klaus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 20 3752

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2020

| Patent document cited in search report | Publication date | Patent family member(s) | Publication date |
|---|---|---|---|
| US 2006238761 A1 | 26-10-2006 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A

- US 2011102753 A1
- US 20120044470 A
- US 20120123581 A
- US 20130258310 A
- US 20130271740 A
- WO 2013178422 A1